# EUROPÄISCHE PATENTSCHRIFT

(11) **EP 2 794 361 B1**
(45) Veröffentlichungstag und Bekanntmachung des Hinweises auf die Patenterteilung: **16.10.2019**
(21) Anmeldenummer: 12812978.0
(22) Anmeldetag: 21.12.2012
(51) Int. Cl.: B60R 21/017, B60R 16/03

(54) **VORRICHTUNG UND VERFAHREN ZUR ÜBERWACHUNG EINER SPANNUNGSVERSORGUNG FÜR EIN FAHRZEUGSYSTEM**
METHOD AND DEVICE FOR MONITORING A VOLTAGE SUPPLY FOR A VEHICLE SYSTEM
DISPOSITIF ET PROCÉDÉ DE SURVEILLANCE D'UNE ALIMENTATION EN TENSION POUR UN SYSTÈME DE VÉHICULE

(30) Priorität: 22.12.2011 DE 102011089556
(43) Veröffentlichungstag der Anmeldung: 29.10.2014
(73) Patentinhaber: Robert Bosch GmbH, 70442 Stuttgart (DE)
(72) Erfinder: SIEVERS, Falko, 72762 Reutlingen (DE); CONRADT,Joerg, 70180 Stuttgart (DE); SCHUMACHER; Hartmut, 71691 Freiberg (DE); LIST, Carsten, 74399 Walheim (DE)
(86) Internationale Anmeldenummer: PCT/EP2012/076548
(87) Internationale Veröffentlichungsnummer: WO 2013/092949

(56) Entgegenhaltungen:
- EP-A2- 0 752 592
- DE-A1-102008 012 896
- DE-A1-102010 028 556
- US-A1- 2001 009 337

## Beschreibung

### Stand der Technik

Die Erfindung geht aus von einer Vorrichtung zur Überwachung einer Spannungsversorgung für ein Fahrzeugsystem nach der Gattung des unabhängigen Patentanspruchs 1, und von einem Verfahren zur Überwachung einer Spannungsversorgung für ein Fahrzeugsystem nach der Gattung des unabhängigen Patentanspruchs 6.

In der Offenlegungsschrift DE 10 2008 012 896 A1 werden beispielsweise ein Steuergerät und ein Verfahren zu Ansteuerung von Personenschutzmitteln für ein Fahrzeug beschrieben. Das beschriebene Steuergerät umfasst wenigstens zwei Halbleiterbausteine, welche die Ansteuerung der Personenschutzmittel bewirken. Die Halbleiterbausteine stellen Versorgungsspannungen für das Steuergerät bereit, wobei sich die beiden Halbleiterbausteine in eine Richtung bezüglich der Versorgungsspannungen überwachen. In Abhängigkeit von der Überwachung der Versorgungsspannungen führen die beiden Halbleiterbausteine einen gemeinsamen Rücksetzvorgang für das Steuergerät durch. Wenn alle Versorgungsspannungen innerhalb von vorgegebenen Wertebereichen liegen, dann kann ein Reset-Eingang am Steuergerät freigegeben werden und das Steuergerät kann korrekt mit den Versorgungsspannungen arbeiten.

In der Patentschrift DE 101 27 54 B4 wird beispielsweise ein Verfahren zum Überwachen einer Spannungsversorgung eines Steuergeräts in einem Kraftfahrzeug beschrieben. Bei dem beschriebenen Verfahren unterbricht ein Versorgungsbaustein bei einem erkannten Fehler bei vorhandenen Spannungen, die vom Versorgungsbaustein im Steuergerät erzeugt werden, Komponenten des Steuergeräts über eine Reset-Leitung in ihrer jeweiligen Funktion. Zudem werden die Spannungen durch Bänder und Vorgabewerte auf Fehler überwacht. Des Weiteren wird ein Test der Reset-Leitung des Steuergeräts eingeleitet, wobei dann der Versorgungsbaustein die Komponenten mit periodischen Pulsen über die Reset-Leitung für eine vorgegebene Zeitdauer in ihrer Funktion unterbricht und ein Prozessor die Zeit zwischen den Unterbrechungen zählt, um die Funktionsweise der Reset-Leitung zu überwachen.

Aus der EP 0 752 592 A2 ist ein System und ein Verfahren zum Erkennen von Isolationsfehlern in einer Schaltung, die mit einer niederohmigen Stromquelle oder - senke mit Ruhespannung verbunden werden soll, bekannt. Dabei wird zunächst die Schaltung in aufgetrenntem Zustand mit einer Prüfspannung aus einer strombegrenzten Stromquelle bzw. -senke, deren Ruhespannung einer vorbestimmten Spannung entspricht oder sie über- bzw. unterschreitet, beaufschlagt. Dann wird aus dem Strom- und/oder Spannungs-Verhalten bei der Prüfspannungsbeaufschlagung auf das Vorliegend oder Nichtvorliegen eines Isolationsfehlers geschlossen. Schließlich wird, falls ein solcher vorliegt, eine Fehlermeldung abgegeben und die niederohmige Stromquelle bzw. -senke in der Eigendiagnose nicht mit der Schaltung verbunden. Falls nicht, wird die niederohmige Stromquelle bzw. -senke mit der Schaltung sequentiell für Testzwecke während der Eigendiagnose verbunden.

### Offenbarung der Erfindung

Die erfindungsgemäße Vorrichtung zur Überwachung einer Spannungsversorgung für ein Fahrzeugsystem Fahrzeug mit den Merkmalen des unabhängigen Patentanspruchs 1 und das zugehörige Verfahren zur Überwachung einer Spannungsversorgung für ein Fahrzeugsystem mit den Merkmalen des unabhängigen Patentanspruchs 6 haben demgegenüber den Vorteil, dass eine integrierte Spannungsüberwachung und eine abgeleitete Reset-Funktionalität durch die implementierte Eigenüberwachungsfunktion selbstständig getestet werden können. Das korrespondierende Fahrzeugsystem, beispielsweise ein Airbag-System, kann dadurch auch immer in einen sicheren Zustand versetzt werden, sobald die Funktion der Spannungsüberwachung nicht mehr gewährleistet ist. Dadurch ist es in vorteilhafter Weise möglich, erweiterte Sicherheitsanforderungen (ASIL-D) zu erfüllen.

Der Kern der Erfindung liegt darin, die bereits integrierte Spannungsüberwachung der intern erzeugten Versorgungsspannungen zusätzlich automatisch testen zu können. Eine Freigabe des Systems, d.h. eine volle Funktionalität, ist damit nur möglich, wenn sowohl die Versorgungsspannungen selbst, als auch deren Überwachungsschaltung und eine Rücksetzeinrichtung fehlerfrei sind. Dadurch kann in vorteilhafter Weise eine deutliche höhere Robustheit gegenüber latenten Fehlern (Doppelfehlern) erzielt werden. Das Ergebnis der Überprüfung der Spannungsüberwachung kann beispielsweise unmittelbar als Status-Information an einem ASIC-Pin gemessen oder per Software-Befehl ausgelesen werden kann.

Die Eigendiagnosefunktion ermöglicht es, die für die Spannungsüberwachung verwendeten Spannungskomparatoren initial zu testen und somit die korrekte Ausgabe der Status-Information bzw. die Ableitung des Reset-Signals sicher zu stellen. Während des Tests der Spannungskomparatoren kann überprüft werden, ob das Ausgangssignal der Spannungskomparatoren seinen logischen Zustand abhängig vom Eingangssignal wechseln kann und ob die Status-Information bzw. das Reset-Signal korrekt abgeleitet werden können. Zusätzlich ist es möglich, statische oder dynamische Kurzschlüsse an den Status- bzw. Reset-Leitungen zu erkennen, indem ein initial zurückgemessener Zustand der korrespondierenden Leitung mit einem erwarteten logischen Zustand verglichen wird. Würde hier ein Kurzschluss erkannt werden, der beispielsweise dazu führt, dass keine Reset-Auslösung bzw. ein Versetzen des Systems in einen sicheren Zustand möglich ist, so ist eine Abschaltung der überwachten Spannungsversorgung bzw. aller im Fahrzeugsystem vorhandenen Spannungsversorgungen möglich. Damit kann in vorteilhafter Weise sichergestellt werden, dass entweder die Spannungsüberwachung und die Reset-Auslösung funktionieren oder das Fahrzeugsystem durch Abschaltung der Spannungsversorgungen vor Schäden geschützt wird. Für den Fall, dass mindestens ein Fehler erkannt wird, wird zuverlässig ein Rücksetzvorgang ausgelöst, welcher das Fahrzeugsystem im sicheren Zustand hält, so dass keine Gefahren durch Fehlauslösungen usw. auftreten können.

Ausführungsformen der vorliegenden Erfindung stellen eine Vorrichtung zur Überwachung einer Spannungsversorgung für ein Fahrzeugsystem zur Verfügung, welche mindestens eine Vergleichseinrichtung, welche eine Ausgabespannung der Spannungsversorgung und/oder eine daraus abgeleitete Spannung als erstes Eingangssignal mit einer vorgegebenen Schwellwertspannung als zweites Eingangssignal vergleicht und ein korrespondierendes Vergleichssignal ausgibt, und eine Rücksetzeinrichtung umfasst, welche in Abhängigkeit des mindestens einen Vergleichssignals mindestens ein Rücksetzsignal erzeugt. Erfindungsgemäß ist eine Eigendiagnosefunktion implementiert, welche einen logischen Zustand des von der mindestens einen Vergleichseinrichtung ausgegebenen Vergleichssignals in Abhängigkeit eines Eingangssignals auswertet und überprüft, ob ein mit dem ausgegebenen Vergleichssignal korrespondierendes Rücksetzsignal erzeugbar ist. Die Eigendiagnosefunktion erkennt eine Fehlfunktion der Vergleichseinrichtung, wenn der ausgewertete logische Zustand des Vergleichssignals nicht mit einem erwarteten logischen Zustand übereinstimmt.

Die Eigendiagnosefunktion erkennt eine Fehlfunktion der Rücksetzeinrichtung, wenn der überprüfte logische Zustand des Rücksetzsignals nicht mit einem erwarteten logischen Zustand übereinstimmt.

Des Weiteren wird ein Verfahren zur Überwachung einer Spannungsversorgung für ein Fahrzeugsystem vorgeschlagen. Hierbei wird über mindestens eine Vergleichseinrichtung eine Ausgabespannung der Spannungsversorgung und/oder eine daraus abgeleitete Spannung als erstes Eingangssignal mit einer vorgegebenen Schwellwertspannung als zweites Eingangssignal verglichen und ein korrespondierendes Vergleichssignal erzeugt. Über eine Rücksetzeinrichtung wird in Abhängigkeit des mindestens einen Vergleichssignals mindestens ein Rücksetzsignal erzeugt. Erfindungsgemäß wird eine Eigendiagnosefunktion implementiert, welche einen logischen Zustand des von der mindestens einen Vergleichseinrichtung ausgegebenen Vergleichssignals in Abhängigkeit eines Eingangssignals auswertet und überprüft, ob ein mit dem ausgegebenen Vergleichssignal korrespondierendes Rücksetzsignal erzeugt werden kann. Eine Fehlfunktion der Vergleichseinrichtung wird von der Eigendiagnosefunktion erkannt, wenn der ausgewertete logische Zustand des Vergleichssignals nicht mit einem erwarteten logischen Zustand übereinstimmt. Eine Fehlfunktion der Rücksetzeinrichtung wird von der Eigendiagnosefunktion erkannt, wenn der überprüfte logische Zustand des Rücksetzsignals nicht mit einem erwarteten logischen Zustand übereinstimmt.

Ausführungsformen der vorliegenden Erfindung führen je nach Systemanforderungen die Eigendiagnosefunktion der mindestens einen Vergleichseinrichtung nicht für alle Ausgabespannungen bzw. nicht für beide Bandgrenzen (Überspannung und Unterspannung) durch. Es ist beispielsweise möglich, einen Teil der Sicherheitsanforderungen auch durch redundantes Schaltungsdesign in Form einer doppelten unabhängigen Überwachung zu erfüllen. Das Resultat der Überprüfung der mindestens einen Vergleichseinrichtungen und das Ergebnis der Überprüfung der Rücksetzeinrichtung kann unterschiedlich verwendet werden. So kann für den Fall, dass eine Überprüfung der mindestens einen Vergleichseinrichtung fehlschlägt ein aktiver Rücksetzvorgang für ein korrespondierendes Airbag-Steuergerät ausgelöst werden. Somit ist das Airbag-System nicht auslösefähig und ein sicherer Zustand ist erreicht. Für den Fall, dass während der Überprüfung der Rücksetzeinrichtung ein Kurzschluss am Rücksetzsignal erkannt wird, kann die Abschaltung der zentralen Spannungsversorgung erfolgen, was ebenfalls zu einem sicheren Systemzustand führt.

Des Weiteren können Ausführungsformen der vorliegenden Erfindung die Überprüfung der einzelnen Vergleichseinrichtungen, das Vorgeben der einzelnen Schwellwertspannungen und das Rücklesen der Ausgangssignale entweder automatisch über geeignete Hardwareelemente oder über eine System-Software, unter Kontrolle eines Mikrokontrollers, programmiert durchführen. Bei der automatischen Steuerung mittels Hardwareelementen kann das Fahrzeugsystem durch Ausgabe eines "Nicht-Reset-Signals" erst dann voll aktiviert werden, wenn alle Spannungen stabil sind und die Überprüfungen aller Vergleichseinrichtungen erfolgreich waren. Bei der Steuerung mittels Software ist es zunächst erforderlich, das Rücksetzsignal auf einen "Nicht-Reset-Zustand" zu setzen, wenn die verschiedenen Spannungen stabil sind; erst danach kann die Überprüfung der mindestens einen Vergleichseinrichtung wie beschrieben gestartet und durchgeführt werden. Danach kann das Rücksetzsignal bei einem erkannten Fehler wieder auf einen aktiven "Reset-Zustand" gesetzt werden.

Durch die in den abhängigen Ansprüchen aufgeführten Maßnahmen und Weiterbildungen sind vorteilhafte Verbesserungen der im unabhängigen Patentanspruch 1 angegebenen Vorrichtung zur Überwachung einer Spannungsversorgung für ein Fahrzeugsystem und eines im unabhängigen Patentanspruch 6 angegebenen Verfahrens zur Überwachung einer Spannungsversorgung für ein Fahrzeugsystem möglich.

Besonders vorteilhaft ist, dass die Eigendiagnosefunktion zentral in einem Steuergerät oder verteilt in den einzelnen Spannungsversorgungen implementiert ist, wobei die Eigendiagnosefunktion zur Kurzschlusserkennung ein von der Rücksetzeinrichtung ausgegebenes Rücksetzsignal zurückliest und mit einem erwarteten logischen Zustand vergleicht, wobei die Eigendiagnosefunktion eine Fehlfunktion der Rücksetzeinrichtung erkennt, wenn der überprüfte logische Zustand des zurückgelesenen Rücksetzsignals nicht mit dem erwarteten logischen Zustand übereinstimmt.

In vorteilhafter Ausgestaltung der erfindungsgemäßen Vorrichtung führt die Eigendiagnosefunktion in Abhängigkeit von vorgegebenen Zeitpunkten und/oder Systemzuständen die Überprüfung der Vergleichseinrichtung und/oder der Rücksetzeinrichtung durch. Dadurch kann die Eigendiagnosefunktion optimal an verschiedene Ausführungsformen der zu überprüfenden Fahrzeugsysteme angepasst werden.

In weiterer vorteilhafter Ausgestaltung der erfindungsgemäßen Vorrichtung kann eine erste Vergleichseinrichtung einer Unterspannungsüberwachung ein erstes Eingangssignals mit einer vorgegebenen ersten Schwellwertspannung als zweites Eingangssignal vergleichen und ein korrespondierendes erstes Vergleichssignal ausgeben. Die Eigendiagnosefunktion kann den logischen Zustand des ersten Vergleichssignals während einer Hochlaufphase der Spannungsversorgung erfassen, in welcher das erste Eingangssignal zustandsbedingt niedriger als das zweite Eingangssignal ist, und den erfassten logischen Zustand mit einem logischen Zustand des ersten Vergleichssignals vergleichen, welchen die Eigendiagnosefunktion zu einem nachfolgenden Zeitpunkt erfasst, an welchem die Spannungsversorgung im Betriebszustand ist und das erste Eingangssignal zustandsbedingt höher als das zweite Eingangssignal ist. Hierbei kann die Eigendiagnosefunktion eine Fehlfunktion der Unterspannungsüberwachung erkennen, wenn die beiden erfassten logischen Zustände des ersten Vergleichssignals gleich sind oder nicht mit erwarteten logischen Zuständen übereinstimmen. Zusätzlich oder alternativ kann eine zweite Vergleichseinrichtung einer Überspannungsüberwachung eine aus der Ausgabespannung der Spannungsversorgung abgeleitete erste Spannung als ein erstes Eingangssignal mit einer vorgegebenen zweiten Schwellwertspannung als zweites Eingangssignal vergleichen und ein korrespondierendes zweites Vergleichssignal ausgeben. Die Eigendiagnosefunktion kann den logischen Zustand des zweiten Vergleichssignals während einer Betriebsphase der Spannungsversorgung erfassen, in welcher das erste Eingangssignal zustandsbedingt höher als das zweite Eingangssignal ist. Zudem kann die Eigendiagnosefunktion zu einem nachfolgenden Zeitpunkt über eine Umschalteinheit eine aus der Ausgabespannung der Spannungsversorgung abgeleitete zweite Spannung als erstes Eingangssignal an die zweite Vergleichseinheit anlegen, welche zustandsbedingt niedriger als die zweite Eingangsspannung ist, und den korrespondierenden logischen Zustand des zweiten Vergleichssignals mit dem vorherigen logischen Zustand des zweiten Vergleichssignals vergleichen. Hierbei kann die Eigendiagnosefunktion eine Fehlfunktion der Überspannungsüberwachung erkennen, wenn die beiden erfassten logischen Zustände des zweiten Vergleichssignals gleich sind oder nicht mit erwarteten logischen Zuständen übereinstimmen.

In vorteilhafter Ausgestaltung des erfindungsgemäßen Verfahrens kann zur Kurzschlusserkennung ein ausgegebenes Rücksetzsignal von der Eigendiagnosefunktion zurückgelesen und mit einem erwarteten logischen Zustand verglichen werden, wobei eine Fehlfunktion der Rücksetzeinrichtung von der Eigendiagnosefunktion erkannt wird, wenn der überprüfte logische Zustand des Rücksetzsignals nicht mit dem erwarteten logischen Zustand übereinstimmt.

In weiterer vorteilhafter Ausgestaltung des erfindungsgemäßen Verfahrens kann die Eigendiagnosefunktion in Abhängigkeit von vorgegebenen Zeitpunkten und/oder Systemzuständen durchgeführt werden.

In weiterer vorteilhafter Ausgestaltung des erfindungsgemäßen Verfahrens kann ein erstes Eingangssignal von einer ersten Vergleichseinrichtung einer Unterspannungsüberwachung mit einer vorgegebenen ersten Schwellwertspannung als zweites Eingangssignal verglichen und ein korrespondierendes erstes Vergleichssignal ausgegeben werden. Der logische Zustand des ersten Vergleichssignals kann während einer Hochlaufphase der Spannungsversorgung, in welcher das erste Eingangssignal zustandsbedingt niedriger als das zweite Eingangssignal ist, von der Eigendiagnosefunktion erfasst und mit einem logischen Zustand des ersten Vergleichssignals verglichen werden, welcher von der Eigendiagnosefunktion zu einem nachfolgenden Zeitpunkt erfasst wird, an welchem die Spannungsversorgung im Betriebszustand ist und das erste Eingangssignal zustandsbedingt höher als das zweite Eingangssignal ist. Eine Fehlfunktion der Unterspannungsüberwachung kann von der Eigendiagnosefunktion erkannt werden, wenn die beiden erfassten logischen Zustände des ersten Vergleichssignals gleich sind oder nicht mit erwarteten logischen Zuständen übereinstimmen. Zusätzlich oder alternativ kann eine zweite Vergleichseinrichtung einer Überspannungsüberwachung eine aus der Ausgabespannung der Spannungsversorgung abgeleitete erste Spannung als ein erstes Eingangssignals mit einer vorgegebenen zweiten Schwellwertspannung als zweites Eingangssignal vergleichen und ein korrespondierendes zweites Vergleichssignal ausgeben. Der logische Zustand des zweiten Vergleichssignals kann während einer Betriebsphase der Spannungsversorgung, in welcher das erste Eingangssignal zustandsbedingt höher als das zweite Eingangssignal ist, von der Eigendiagnosefunktion erfasst werden, welche zu einem nachfolgenden Zeitpunkt eine aus der Ausgabespannung der Spannungsversorgung abgeleitete zweite Spannung als erstes Eingangssignal an die zweite Vergleichseinheit anlegt, welche zustandsbedingt niedriger als die zweite Eingangsspannung ist. Den korrespondierenden logischen Zustand des zweiten Vergleichssignals kann mit dem vorherigen logischen Zustand des zweiten Vergleichssignals verglichen werden, wobei eine Fehlfunktion der Überspannungsüberwachung von der Eigendiagnosefunktion erkannt werden kann, wenn die beiden erfassten logischen Zustände des zweiten Vergleichssignals gleich sind oder nicht mit erwarteten logischen Zuständen übereinstimmen.

Ausführungsbeispiele der Erfindung sind in den Zeichnungen dargestellt und werden in der nachfolgenden Beschreibung näher erläutert. In den Zeichnungen bezeichnen gleiche Bezugszeichen Komponenten bzw. Elemente, die gleiche bzw. analoge Funktionen ausführen.

Kurze Beschreibung der Zeichnungen
Fig. 1 zeigt ein schematisches Blockdiagramm eines Ausführungsbeispiels einer erfindungsgemäßen Vorrichtung zur Überwachung einer Spannungsversorgung für ein Fahrzeugsystem.
Fig. 2 bis 8 zeigen ein schematisches Flussdiagram eines Ausführungsbeispiels eines erfindungsgemäßen Verfahrens zur Überwachung einer Spannungsversorgung für ein Fahrzeugsystem.

### Ausführungsformen der Erfindung

Aktuelle Airbag-Steuergeräte zeichnen sich unter anderem dadurch aus, dass alle Versorgungsspannungen, welcher für den Betrieb des Airbag-Systems benötigt werden, innerhalb des Airbag-Systems selbst erzeugt werden. Somit ist sichergestellt, dass eine korrekte Funktionalität unabhängig von Schwankungen der Batteriespannung im Fahrzeug gegeben ist. Des Weiteren ist eine Überwachung der systemrelevanten Versorgungsspannungen zur Versorgung von Analog- und Digitalfunktionen integriert. Die Überwachung garantiert, dass das Airbag-System in einen sicheren Zustand versetzt wird, sobald eine der Versorgungsspannungen den spezifizierten Spannungsbereich, beispielsweise durch interne oder externe Fehler oder durch Wegfall/Abschaltung der Spannung der Fahrzeugbatterie verlässt. Diese Funktion kann durch ein systeminternes Rücksetzsignal realisiert werden, welches alle versorgten aktiven Systembausteine in einen sicheren Aus-Zustand versetzt. Dadurch können Fehlfunktionen aufgrund unzulässiger Versorgungsspannungen so gut wie ausgeschlossen werden.

Die bislang implementierten Spannungsüberwachungen für Spannungsversorgungen, die beispielsweise als Linearregler oder DC/DC-Schaltwandler oder Spannungsquelle ausgeführt sind, sind größtenteils so aufgebaut, dass die geregelte Ausgabespannung an einer Unterspannungsschwelle und/oder einer Überspannungsschwelle mittels mindestens einem Spannungskomparator überwacht werden. Sollte sich die Ausgabespannung außerhalb des zulässigen Bereichs befinden, wird dieser Zustand über den mindestens einen Spannungskomparator erkannt, so dass entsprechende analoge und/oder logische Zustände bzw. Reaktionen abgeleitet werden können. Das auf dem Vergleichsergebnis basierende Vergleichssignal des mindestens einen Spannungskomparators kann dabei beispielsweise in Form einer Status-Information ausgegeben und/oder zum Auslösen eines Rücksetzsignals verwendet werden.

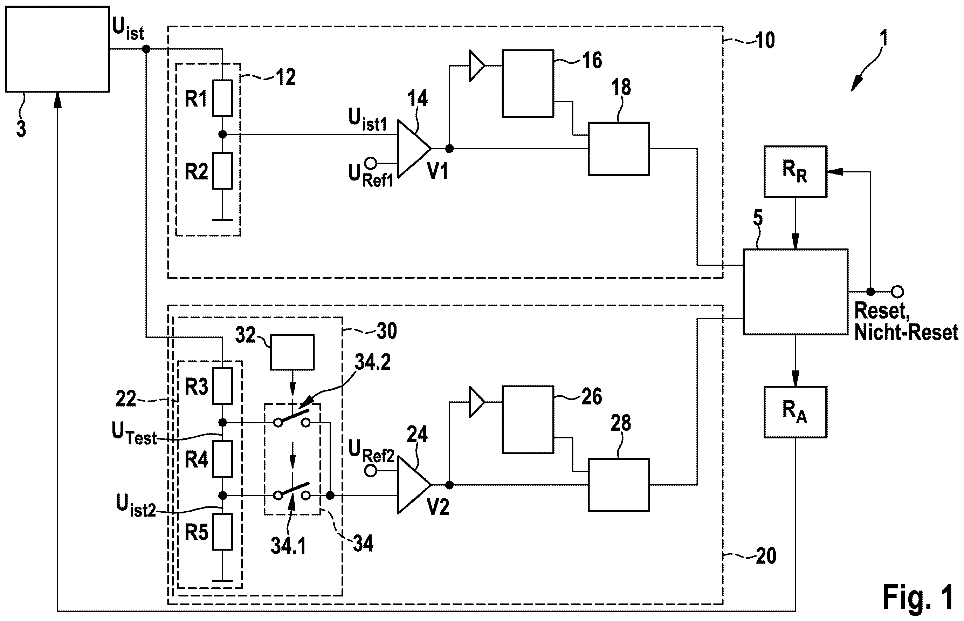

Wie aus Fig. 1 ersichtlich ist, umfasst das dargestellte Ausführungsbeispiel einer erfindungsgemäßen Vorrichtung 1 zur Überwachung einer Spannungsversorgung 3 für ein Fahrzeugsystem mindestens eine Vergleichseinrichtung 14, 24, welche eine Ausgabespannung Uᵢₛₜ der Spannungsversorgung 3 und/oder eine daraus abgeleitete Spannung Uᵢₛₜ₁, Uᵢₛₜ₂, U_{Test} als erstes Eingangssignal mit einer vorgegebenen Schwellwertspannung U_{Ref1}, U_{Ref2} als zweites Eingangssignal vergleicht und ein korrespondierendes Vergleichssignal V1, V2 ausgibt, und eine Rücksetzeinrichtung 5, welche in Abhängigkeit des mindestens einen Vergleichssignals V1, V2 mindestens ein Rücksetzsignal Reset, Nicht-Reset erzeugt.

Erfindungsgemäß ist eine Eigendiagnosefunktion implementiert, welche einen logischen Zustand des von der mindestens einen Vergleichseinrichtung 14, 24 ausgegebenen Vergleichssignals V1, V2 in Abhängigkeit eines Eingangssignals U_{ist1,} Uᵢₛₜ₂, U_{Test} auswertet und überprüft, ob ein mit dem ausgegebenen Vergleichssignal V1, V2 korrespondierendes Rücksetzsignal Reset, Nicht-Reset erzeugbar ist. Hierbei erkennt die Eigendiagnosefunktion eine Fehlfunktion der Vergleichseinrichtung 14, 24, wenn der ausgewertete logische Zustand des Vergleichssignals V1, V2 nicht mit einem erwarteten logischen Zustand übereinstimmt. Die Eigendiagnosefunktion erkennt eine Fehlfunktion der Rücksetzeinrichtung 5, wenn der überprüfte logische Zustand des Rücksetzsignals Reset, Nicht-Reset nicht mit einem erwarteten logischen Zustand übereinstimmt.

Wie aus Fig. 1 weiter ersichtlich ist, umfasst die Spannungsüberwachungsvorrichtung 1 für die Spannungsversorgung 3 im dargestellten Ausführungsbeispiel eine Unterspannungsüberwachung 10 und eine Überspannungsüberwachung 20.

Eine erste Vergleichseinrichtung 14 der Unterspannungsüberwachung 10 ist als Spannungskomparator ausgeführt, welcher ein erstes Eingangssignals, welches als Spannung Uᵢₛₜ₁ über einen aus zwei Widerständen R1, R2 bestehenden ersten Spannungsteiler 12 von der Ausgabespannung Uᵢₛₜ der Spannungsversorgung 3 abgeleitet wird, mit einer vorgegebenen ersten Schwellwertspannung U_{Ref1} als zweites Eingangssignal vergleicht. Die erste Vergleichseinrichtung 14 gibt ein korrespondierendes erstes Vergleichssignal V1 aus. Das erste Vergleichssignal V1 wird über ein erstes Fehler-Flip-Flop 16, vorzugsweise ein D-Flip-Flop, und eine zugehörige erste Auswertelogik 18 überwacht, um zu überprüfen, ob das erste Vergleichssignal V1 der ersten Vergleichseinrichtung 14 während der Eigendiagnosefunktion einmal von einem ersten Zustand "Schlecht" auf einen zweiten Zustand "Gut" wechselt. Daher erfasst die Eigendiagnosefunktion den logischen Zustand des ersten Vergleichssignals V1 während einer Hochlaufphase der Spannungsversorgung 3, in welcher das erste Eingangssignal Uᵢₛₜ₁ zustandsbedingt niedriger als das zweite Eingangssignal U_{Ref1} ist. Die Eigendiagnosefunktion vergleicht den während der Hochlaufphase erfassten logische Zustand des ersten Vergleichssignals V1, welcher den erwarteten ersten Zustand "Schlecht" repräsentiert, mit einem logischen Zustand des ersten Vergleichssignals V1, welchen die Eigendiagnosefunktion zu einem nachfolgenden Zeitpunkt erfasst. An diesem nachfolgenden Zeitpunkt befindet sich die Spannungsversorgung 3 im Betriebszustand und das erste Eingangssignal Uᵢₛₜ₁ ist zustandsbedingt höher als das zweite Eingangssignal U_{Ref1}, so dass der erwartete Zustand des nachfolgend erfassten logischen Zustands dem zweiten Zustand "Gut" entspricht. Die Eigendiagnosefunktion erkennt eine Fehlfunktion der Unterspannungsüberwachung 10, wenn die beiden erfassten logischen Zustände des ersten Vergleichssignals V1 gleich sind, bzw. der erwartete logische Zustand des Vergleichssignals nicht mit dem erfassten logischen Zustand des Vergleichssignals übereinstimmt.

Analog zur ersten Vergleichseinrichtung 14 der Unterspannungsüberwachung 10 ist eine zweite Vergleichseinrichtung 24 der Überspannungsüberwachung 20 als Spannungskomparator ausgeführt, welcher über eine Umschalteinheit 30 eine von der Ausgabespannung Uᵢₛₜ der Spannungsversorgung 3 abgeleitete Spannung Uᵢₛₜ₂, U_{Test} als ein erstes Eingangssignal empfängt. Die Umschalteinheit 30 umfasst einen aus drei Widerständen R3, R4, R5 aufgebauten zweiten Spannungsteiler 22, welcher zwei aus der Ausgabespannung Uᵢₛₜ der Spannungsversorgung 3 abgeleitete Spannungen Uᵢₛₜ₂, U_{Test} als erstes Eingangssignal zur Verfügung stellt, und eine von einer Steuerlogik 32 angesteuerte Schalteinheit 34 mit zwei Schaltelementen 34.1, 34.2 zur Auswahl von einer der beiden abgeleiteten Spannungen Uᵢₛₜ₂, U_{Test} als erstes Eingangssignal. Das Teilerverhältnis des zweiten Spannungsteilers 22 ist so gewählt, dass eine von der Ausgabespannung Uᵢₛₜ der im Normalbetrieb arbeitenden Spannungsversorgung 3 abgeleitete erste Spannung U_{Test} höher und eine von der Ausgabespannung Uᵢₛₜ der im Normalbetrieb arbeitenden Spannungsversorgung 3 abgeleitete zweite Spannung Uᵢₛₜ₂ niedriger als eine als zweites Eingangssignal vorgegebene Schwellwertspannung U_{Ref2} ist.

Zur Überprüfung der Überspannungsüberwachung 20 legt die Eigendiagnosefunktion während einer Betriebsphase zu einem ersten Zeitpunkt die abgeleitete erste Spannung U_{Test} über ein erstes Schaltelement 34.2 als erstes Eingangssignal Uᵢₛₜ₂ an die zweite Vergleichseinrichtung 24 an, wobei ein zweites Schaltelement 34.1 zum ersten Zeitpunkt geöffnet ist. Die zweite Vergleichseinrichtung 24 vergleicht das erste Eingangssignal U_{Test} mit der vorgegebenen zweiten Schwellwertspannung U_{Ref2} als zweites Eingangssignal und gibt ein korrespondierendes zweites Vergleichssignal V2 aus. Das zweite Vergleichssignal V2 wird analog zum ersten Vergleichssignal V1 über ein zweites Fehler-Flip-Flop 26, vorzugsweise ein D-Flip-Flop, und eine zugehörige zweite Auswertelogik 28 überwacht, um zu überprüfen, ob das zweite Vergleichssignal V2 der zweiten Vergleichseinrichtung 24 während der Eigendiagnosefunktion einmal vom ersten Zustand "Schlecht" auf den zweiten Zustand "Gut" wechselt. Da die Eigendiagnosefunktion den logischen Zustand des zweiten Vergleichssignals V2 erfasst während die erste abgeleitete Spannung U_{Test} als erstes Eingangssignal an der zweiten Vergleichseinrichtung 24 angelegt ist, welche zustandsbedingt höher als das zweite Eingangssignal U_{Ref1} ist, entspricht der erwartete logische Zustand des zweiten Vergleichssignals V2 dem ersten Zustand "Schlecht". Zur weiteren Überprüfung der Überspannungsüberwachung 20 legt die Eigendiagnosefunktion während der Betriebsphase zu einem nachfolgenden zweiten Zeitpunkt die abgeleitete zweite Spannung Uᵢₛₜ₂ über ein zweites Schaltelement 34.1 als erstes Eingangssignal an die zweite Vergleichseinrichtung 24 an, wobei das erste Schaltelement 34.2 zum zweiten Zeitpunkt geöffnet ist. Die zweite Vergleichseinrichtung 24 vergleicht das erste Eingangssignal Uᵢₛₜ₂ mit der vorgegebenen zweiten Schwellwertspannung U_{Ref2} als zweites Eingangssignal und gibt ein korrespondierendes zweites Vergleichssignal V2 aus. Da die Eigendiagnosefunktion den logischen Zustand des zweiten Vergleichssignals V2 erfasst während die zweite abgeleitete Spannung Uᵢₛₜ₂ als erstes Eingangssignal an der zweiten Vergleichseinrichtung 24 angelegt ist, welche zustandsbedingt niedriger als das zweite Eingangssignal U_{Ref1} ist, entspricht der erwartete logische Zustand des zweiten Vergleichssignals V2 dem zweiten Zustand "Gut". Die Eigendiagnosefunktion erkennt eine Fehlfunktion der Überspannungsüberwachung 20, wenn die beiden erfassten logischen Zustände des zweiten Vergleichssignals V2 gleich sind, bzw. der erwartete logische Zustand des Vergleichssignals nicht mit dem erfassten logischen Zustand des Vergleichssignals übereinstimmt.

Alternativ zum ersten bzw. zweiten Fehler-Flip-Flop 16, 26 und der ersten bzw. zweiten Auswertelogik 18, 28 kann die Überwachung des ersten bzw. zweiten Vergleichssignals V1, V2 über entsprechende Software-Befehle, welche die logischen Zustände auslesen, und durch ein auf einem Prozessor ablaufenden Software-Programm realisiert werden, welches die ausgelesenen logischen Zustände des ersten bzw. zweiten Vergleichssignals V1, V2 überprüft.

Zudem kann die in Verbindung mit der Überspannungsüberwachung 20 beschriebene Umschalteinheit 30 auch für die Unterspannungsüberwachung 10 eingesetzt werden, wobei dann das Teilerverhältnis des zweiten Spannungsteilers 22 so gewählt wird, dass eine von der Ausgabespannung Uᵢₛₜ der im Normalbetrieb arbeitenden Spannungsversorgung 3 abgeleitete erste Spannung U_{Test} niedriger und eine von der Ausgabespannung Uᵢₛₜ der im Normalbetrieb arbeitenden Spannungsversorgung 3 abgeleitete zweite Spannung Uᵢₛₜ₂ höher als eine als zweites Eingangssignal vorgegebene Schwellwertspannung U_{Ref1} ist. So dass während der Überprüfung der Unterspannungsüberwachung 10 zuerst der erste Zustand "Schlecht" und dann der zweite Zustand "Gut" erkannt wird. Dadurch ist es möglich die Eigendiagnose der Spannungsüberwachung nicht nur während des Hochfahrens der Spannungsversorgung 3 sondern auch zu beliebigen Zeitpunkten durchzuführen.

Die Eigendiagnosefunktion ist zentral in einem Steuergerät des korrespondierenden Fahrzeugsystems, beispielsweise in einem Airbag-Steuergerät, oder verteilt in den einzelnen Spannungsversorgungen 3 implementiert. Hierbei liest die Eigendiagnosefunktion zur Kurzschlusserkennung ein von der Rücksetzeinrichtung 5 ausgegebenes Rücksetzsignal Reset, Nicht-Reset zurück und vergleicht es mit einem zu erwartenden logischen Zustand. Hierbei erkennt die Eigendiagnosefunktion eine Fehlfunktion der Rücksetzeinrichtung 5, wenn der überprüfte logische Zustand des zurückgelesenen Rücksetzsignals R_{R} nicht mit dem erwarteten logischen Zustand übereinstimmt. Bei einem erkannten Kurzschluss am Ausgang der Rücksetzeinrichtung 5 kann somit über ein Abschaltsignal R_{A} eine Sicherheitsabschaltung der Spannungsversorgung 3 erfolgen.

Damit ist sichergestellt, dass entweder die Spannungsüberwachung, in Form der Unterspannungsüberwachung 10 und der Überspannungsüberwachung 20, und die Auslösung des Rücksetzsignals "Reset", "Nicht-Reset" funktioniert oder das Fahrzeugsystem durch Abschaltung der Spannungsversorgung 3 vor Schäden geschützt wird. Für den Fall, dass mindestens ein Fehler erkannt wird, wird zuverlässig das aktive "Reset-Signal" ausgelöst, welcher das System im sicheren Zustand hält.

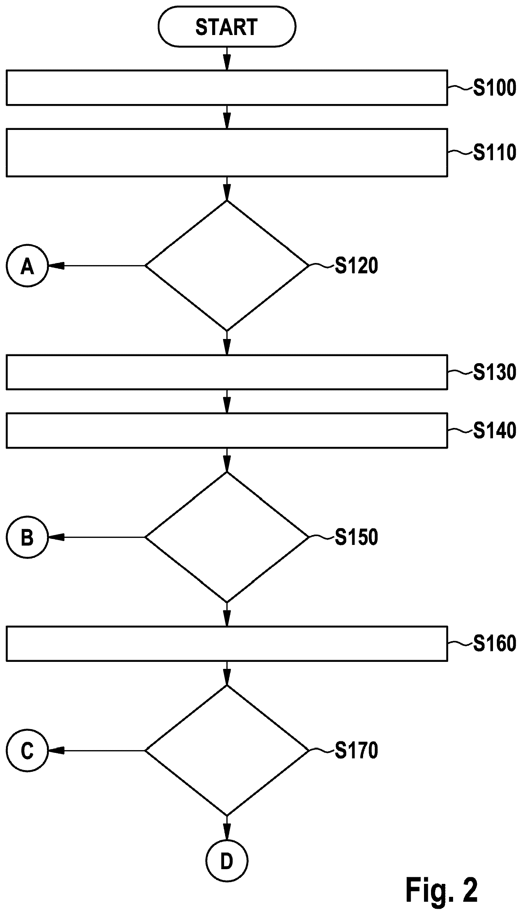

Nachfolgend wird unter Bezugnahme auf Fig. 2 bis 8 ein Ausführungsbeispiel des erfindungsgemäßen Verfahrens zur Überwachung einer Spannungsversorgung 3 für ein Fahrzeugsystem beschrieben.

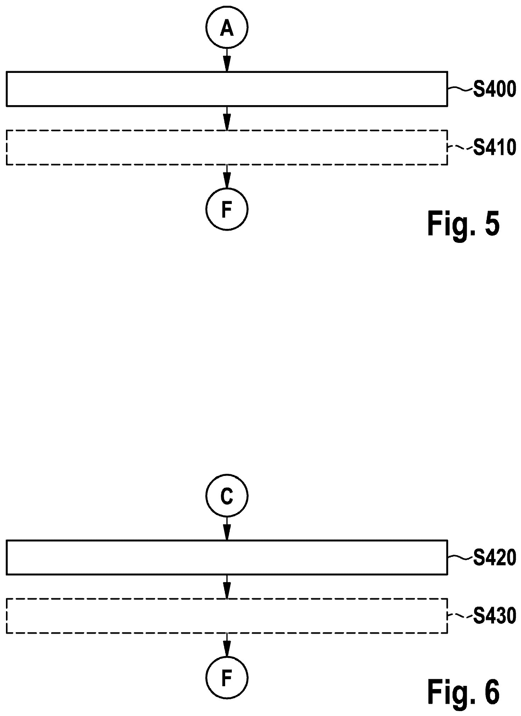

Wie aus Fig. 2 weiter ersichtlich ist, wird im Schritt S100 die zu überwachende Spannungsversorgung 3 aktiviert. Während der Hochlaufphase der zu überwachenden Spannungsversorgung 3 wird im Schritt S110 ein Ausgabesignal der Unterspannungsüberwachung 10 ausgelesen. Die erste Vergleichseinrichtung 12 der Unterspannungsüberwachung 10 muss einen Zustand "Unterspannung" bzw. den ersten Zustand "Schlecht" erkennen, da die von der Ausgabespannung Uᵢₛₜ der Spannungsversorgung 3 abgeleitete Spannung Uᵢₛₜ₁ zu diesem Zeitpunkt die vorgegebene Schwellwertspannung U_{Ref1} noch nicht erreicht hat. Alternativ kann über die Umschalteinheit 30 aus der Ausgabespannung Uᵢₛₜ der Spannungsversorgung 3 bewusst eine zu niedrige Spannung als erstes Eingangssignal für die erste Vergleichseinrichtung 12 erzeugt werden, welche niedriger als die vorgegebene Schwellwertspannung U_{Ref1} ist, um den Unterspannungszustand bzw. den ersten Zustand "Schlecht" zu erzeugen. Im Schritt S120 wird überprüft, ob der Unterspannungszustand erkannt wurde. Wurde der Unterspannungszustand erkannt, dann wird das Verfahren mit dem Schritt S130 fortgesetzt. Wurde der Unterspannungszustand nicht erkannt, dann wird das Verfahren mit einer nachfolgend beschriebenen Fehlerbehandlung gemäß dem in Fig. 5 dargestellten Schritt S400 fortgesetzt.

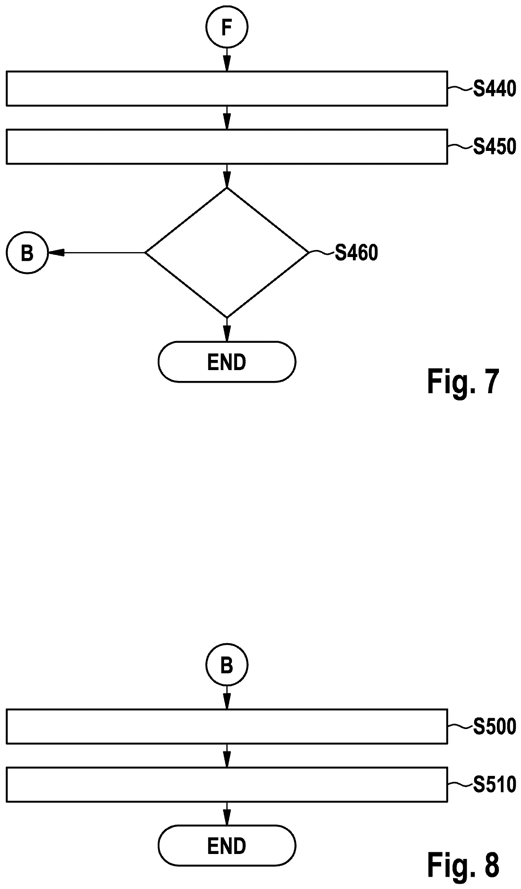

Im Schritt S130 wird aufgrund des erkannten Unterspannungszustands das Rücksetzsignal "Reset" gesetzt und ausgegeben. Im Schritt S140 wird das ausgegebene Rücksetzsignal "Reset" zurückgelesen. Im Schritt S150 wird das zurückgelesene Rücksetzsignal R_{R} dahingehend überprüft, ob das Rücksetzsignal "Reset" gesetzt bzw. aktiv ist. Ist das Rücksetzsignal "Reset" aktiv, dann wird das Verfahren mit dem Schritt S160 fortgesetzt. Ist das Rücksetzsignal "Reset" nicht aktiv, dann wird das Verfahren mit einer nachfolgend beschriebenen Fehlerbehandlung gemäß dem in Fig. 8 dargestellten Schritt S500 fortgesetzt.

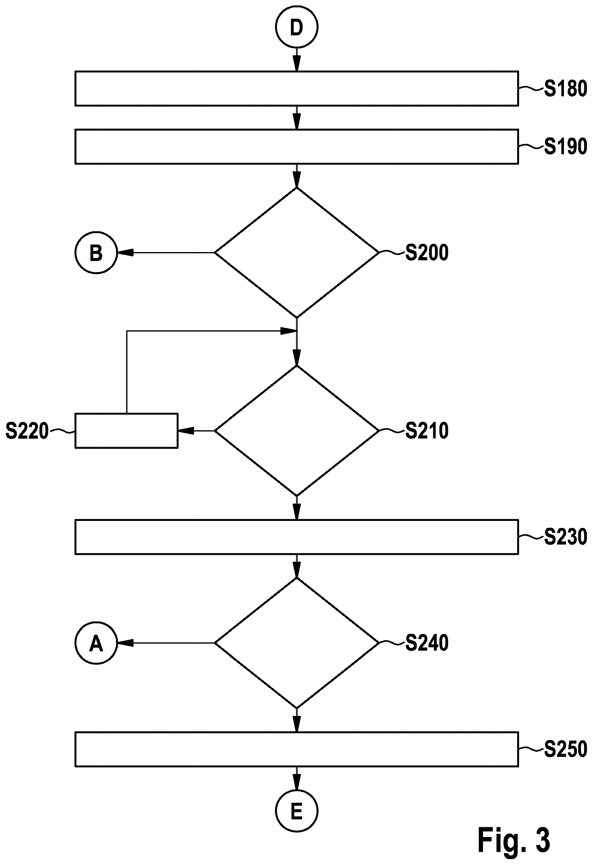

Im Schritt S160 wird die Überspannungstestschwelle gesetzt und die von der Ausgabespannung Uᵢₛₜ der Spannungsversorgung 3 abgeleitete erste Spannung U_{Test} als erstes Eingangssignal an die zweite Vergleichseinrichtung 24 angelegt. Eine Überspannung kann nur im Fehlerfall erreicht werden, wenn beispielsweise der verwendete Spannungsregler fehlerhaft ist oder die Ausgabespannung des Spannungsreglers bzw. der Spannungsquelle einen Kurzschluss zu einer höheren Spannung aufweist. Um die Überprüfung trotzdem bei jedem Systemstart durchführen zu können, wird bewusst ein zu hoher Spannungspegel U_{Test} für den Vergleich mit der vorgegebenen Schwellwertspannung U_{Ref2} zur Überspannungsüberwachung gewählt. Nach dem Setzen des zu hohen Spannungspegels U_{Test} über die Umschalteinheit 30 muss die zweite Vergleichseinrichtung 24 den Zustand "Überspannung" bzw. den ersten Zustand "Schlecht" anzeigen und ausgeben. Im Schritt S170 wird überprüft, ob der Überspannungszustand erkannt wurde. Wurde der Überspannungszustand erkannt, dann wird das Verfahren mit dem in Fig. 3 dargestellten Schritt S180 fortgesetzt. Wurde der Überspannungszustand nicht erkannt, dann wird das Verfahren mit einer nachfolgend beschriebenen Fehlerbehandlung gemäß dem in Fig. 6 dargestellten Schritt S420 fortgesetzt.

Wie aus Fig. 3 weiter ersichtlich ist, wird im Schritt S180 aufgrund des erkannten Überspannungszustand das Rücksetzsignal "Reset" gesetzt und ausgegeben. Im Schritt S190 wird das ausgegebene Rücksetzsignal "Reset" zurückgelesen. Im Schritt S200 wird das zurückgelesene Rücksetzsignal R_{R} dahingehend überprüft, ob das Rücksetzsignal "Reset" gesetzt bzw. aktiv ist. Ist das Rücksetzsignal "Reset" aktiv, dann wird das Verfahren mit dem Schritt S210 fortgesetzt. Ist das Rücksetzsignal "Reset" nicht aktiv, dann wird das Verfahren mit der nachfolgend beschriebenen Fehlerbehandlung gemäß dem in Fig. 8 dargestellten Schritt S500 fortgesetzt. Das basierend auf den Vergleichsspannungen der ersten und zweiten Vergleichseinheit 14, 24 erzeugte Rücksetzsignal "Reset" stellt eine Summeninformation für alle Spannungsüberwachungen im System dar. Daher muss das Rücksetzsignal "Reset" während der Überprüfung der Unterspannungsüberwachung und der Überspannungsüberwachung auf einem aktiven "Reset-Zustand" stehen, d.h. das System wird im Rücksetzzustand bzw. in einem sicheren Aus-Zustand gehalten. Dieser erwartete Zustand des Rücksetzsignals "Reset" wird durch Zurücklesen des ausgegebenen Rücksetzsignals "Reset" überprüft.

Wie aus Fig. 3 weiter ersichtlich ist, wird im Schritt S210 überprüft, ob die Hochlaufphase der Spannungsversorgung 3 beendet ist. Ist die Hochlaufphase noch nicht beendet, dann wird im Schritt S220 eine vorgegebenen Pausenzeit abgewartet und dann die Überprüfung im Schritt S210 erneut durchgeführt. Die Schritte S210 und S220 werden wiederholt, bis die Hochlaufphase als beendet erkannt wurde. Im Schritt S230 wird dann erneut das Ausgabesignal der Unterspannungsüberwachung 10 ausgelesen. Die erste Vergleichseinrichtung 12 der Unterspannungsüberwachung 10 muss einen Zustand "Nicht-Unterspannung" bzw. den zweiten Zustand "Gut" erkennen, da die von der Ausgabespannung Uᵢₛₜ der Spannungsversorgung 3 abgeleitete Spannung Uᵢₛₜ₁ zu diesem Zeitpunkt über der vorgegebenen Schwellwertspannung U_{Ref1} liegen muss. Bei der alternativen Ausführung kann über die Umschalteinheit 30 aus der Ausgabespannung Uᵢₛₜ der Spannungsversorgung 3 bewusst eine Spannung als erstes Eingangssignal für die erste Vergleichseinrichtung 12 erzeugt werden, welche die Ausgabespannung Uᵢₛₜ der Spannungsversorgung 3 repräsentiert und höher als die vorgegebene Schwellwertspannung U_{Ref1} ist, um den Nicht-Unterspannungszustand bzw. den zweiten Zustand "Gut" zu erzeugen. Im Schritt S240 wird überprüft, ob der Nicht-Unterspannungszustand erkannt wurde. Wurde der Nicht-Unterspannungszustand erkannt, dann wird das Verfahren mit dem Schritt S250 fortgesetzt. Wurde der Nicht-Unterspannungszustand nicht erkannt, dann wird das Verfahren mit einer nachfolgend beschriebenen Fehlerbehandlung gemäß dem in Fig. 5 dargestellten Schritt S400 fortgesetzt.

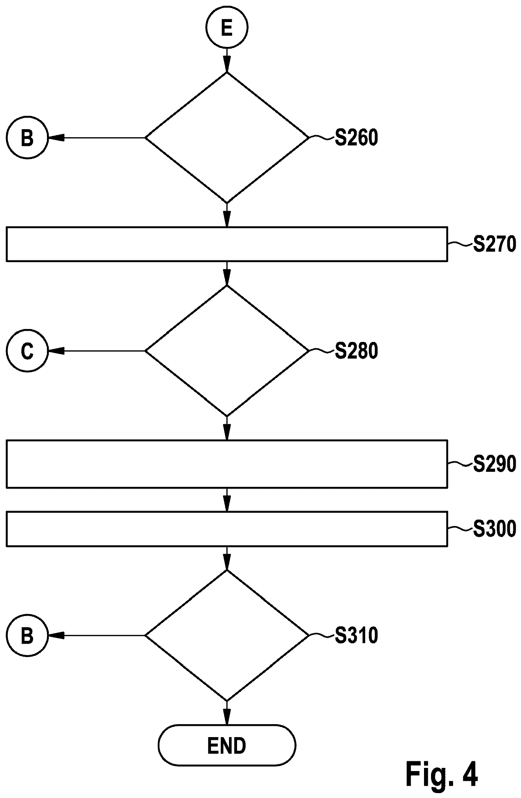

Im Schritt S250 wird das Rücksetzsignal erneut zurückgelesen und das Verfahren mit dem in Fig. 4 dargestellten Schritt S260 fortgesetzt. Im Schritt S260 wird das zurückgelesene Rücksetzsignal R_{R} dahingehend überprüft, ob das Rücksetzsignal "Reset" immer noch gesetzt bzw. aktiv ist. Ist das Rücksetzsignal "Reset" immer noch aktiv, dann wird das Verfahren mit dem Schritt S270 fortgesetzt. Ist das Rücksetzsignal "Reset" nicht mehr aktiv, dann wird das Verfahren mit der nachfolgend beschriebenen Fehlerbehandlung gemäß dem in Fig. 8 dargestellten Schritt S500 fortgesetzt.

Im Schritt S270 wird die Überspannungsschwelle gesetzt. Das bedeutet, dass die von der Ausgabespannung Uᵢₛₜ der Spannungsversorgung 3 abgeleitete zweite Spannung Uᵢₛₜ₂ als erstes Eingangssignal an die zweite Vergleichseinrichtung 24 angelegt wird. Die abgeleitete zweite Spannung Uᵢₛₜ₂ repräsentiert die Ausgabespannung Uᵢₛₜ der Spannungsversorgung 3 und ist im Normalbetrieb niedriger als die vorgegebene Schwellwertspannung U_{Ref2}. Nach dem Setzen des normalen Spannungspegels Uᵢₛₜ₂ über die Umschalteinheit 30 muss die zweite Vergleichseinrichtung 24 den Zustand "Nicht-Überspannung" bzw. den zweiten Zustand "Gut" anzeigen und ausgeben. Im Schritt S280 wird überprüft, ob der Nicht-Überspannungszustand erkannt wurde. Wurde der Nicht-Überspannungszustand erkannt, dann wird das Verfahren mit dem Schritt S290 fortgesetzt. Wurde der Nicht-Überspannungszustand nicht erkannt, dann wird das Verfahren mit der nachfolgend beschriebenen Fehlerbehandlung gemäß dem in Fig. 6 dargestellten Schritt S420 fortgesetzt.

Im Schritt S290 wird aufgrund des erkannten Nicht-Unterspannungszustands und des erkannten Nicht-Überspannungszustand das Rücksetzsignal "Nicht-Reset" gesetzt und ausgegeben. Im Schritt S300 wird das ausgegebene Rücksetzsignal "Nicht-Reset" zurückgelesen. Im Schritt S310 wird das zurückgelesene Rücksetzsignal R_{R} dahingehend überprüft, ob das Rücksetzsignal "Nicht-Reset" gesetzt bzw. aktiv ist. Ist das Rücksetzsignal "Nicht-Reset" aktiv, dann wird das korrespondierende Fahrzeugsystem in einen An-Zustand versetzt. Ist das Rücksetzsignal "Nicht-Reset" nicht aktiv, dann wird das Verfahren mit der nachfolgend beschriebenen Fehlerbehandlung gemäß dem in Fig. 8 dargestellten Schritt S500 fortgesetzt. Sobald die von der Ausgabespannung Uᵢₛₜ abgeleitete Spannung Uᵢₛₜ₁ in das erlaubte (geregelte) Spannungsband einläuft, muss die erste Vergleichseinrichtung 14 der Unterspannungsüberwachung 10 auf den Zustand "Nicht-Unterspannung" wechseln. Des Weiteren wird für die zweite Vergleichseinrichtung 24 der Überspannungsüberwachung 20 der korrekte Spannungspegel Uᵢₛₜ₂ für den Vergleich mit der vorgegebenen Schwellwertspannung U_{Ref2} gewählt. Befindet sich die von der Ausgabespannung Uᵢₛₜ abgeleitete zweite Uᵢₛₜ₂ im gültigen Bereich, d.h. unterhalb der Überspannungsschwelle U_{Ref2}, dann muss die zweite Vergleichseinrichtung 24 nun ebenfalls auf den Zustand "Nicht-Überspannung" wechseln. Erst wenn beide Vergleichseinrichtungen 14, 24 jeweils den "Gut-Zustand", d.h. "Nicht-Unterspannung" und "Nicht-Überspannung" anzeigen, darf das Rücksetzsignal auf den aktiven "Nicht-Reset-Zustand" wechseln und das Fahrzeugsystem wird aktiviert. Auch hier wird der erwartete Zustand des Rücksetzsignals durch Zurücklesen des ausgegebenen Rücksetzsignals überprüft.

Sobald in einem der aufgeführten Überprüfungsschritte ein Fehler erkannt wird, wird ein korrespondierender Fehlerzustand ausgegeben bzw. angezeigt. Dies kann entweder durch Auslösen eines aktiven Rücksetzsignals oder durch Ausgabe einer Status-Information erfolgen, welche beispielsweise über ein Ausgangssignal oder einen Software-Befehl lesbar ist. Außerdem ist es möglich, die betroffene Spannungsversorgung oder andere Spannungsversorgungen bzw. alle Spannungsversorgungen des Fahrzeugsystems aktiv abzuschalten, bis ein System-Neustart erfolgt.

Wie aus 5 ersichtlich ist, wird für den Fall, dass im Schritt S120 der Zustand "Unterspannung" nicht erkannt wurde, oder für den Fall, dass im Schritt S240 der Zustand "Nicht-Unterspannung" nicht erkannt wurde, im Schritt S400 ein entsprechender Fehler ausgegeben, dass die Unterspannungsüberwachung 10 fehlerhaft arbeitet. Zusätzlich kann im Schritt S410 die korrespondierende Spannungsversorgung 3 über ein entsprechendes Abschaltsignal R_{A} abgeschaltet werden, bevor das Verfahren mit dem nachfolgend beschriebenen in Fig. 7 dargestellten Schritt S440 fortgesetzt wird.

Wie aus 6 ersichtlich ist, wird für den Fall, dass im Schritt S170 der Zustand "Überspannung" nicht erkannt wurde, oder für den Fall, dass im Schritt S280 der Zustand "Nicht-Überspannung" nicht erkannt wurde, im Schritt S420 ein entsprechender Fehler ausgegeben, dass die Überspannungsüberwachung 20 fehlerhaft arbeitet. Zusätzlich kann im Schritt S430 die korrespondierende Spannungsversorgung 3 über das Abschaltsignal R_{A} abgeschaltet werden, bevor das Verfahren mit dem nachfolgend beschriebenen in Fig. 7 dargestellten Schritt S440 fortgesetzt wird.

Wie aus Fig. 7 ersichtlich ist, wird im Schritt S440 aufgrund der fehlerhaften Unterspannungsüberwachung 10 bzw. Überspannungsüberwachung 20 das Rücksetzsignal "Reset" gesetzt und ausgegeben. Im Schritt S450 wird das ausgegebene Rücksetzsignal "Reset" zurückgelesen. Im Schritt S460 wird das zurückgelesene Rücksetzsignal R_{R} dahingehend überprüft, ob das Rücksetzsignal "Reset" gesetzt bzw. aktiv ist. Ist das Rücksetzsignal "Reset" aktiv, dann wird das Verfahren beendet und das System wird im Rücksetzzustand bzw. im sicheren Aus-Zustand gehalten. Ist das Rücksetzsignal "Reset" nicht aktiv, dann wird das Verfahren mit einer nachfolgend beschriebenen Fehlerbehandlung gemäß dem in Fig. 8 dargestellten Schritt S500 fortgesetzt.

Wie aus 8 ersichtlich ist, wird für den Fall, dass im Schritt S150 bzw. im Schritt S200 bzw. im Schritt S260 bzw. im Schritt S460 der Zustand des Rücksetzsignals "Reset" nicht aktiv war, oder für den Fall, dass im Schritt S310 der Zustand des Rücksetzsignals "Nicht-Reset" nicht aktiv war, im Schritt S500 ein entsprechender Fehler ausgegeben, dass die Rücksetzeinrichtung 5 fehlerhaft arbeitet. Im Schritt S510 werden im dargestellten Ausführungsbeispiel alle Spannungsversorgungen des Fahrzeugsystems abgeschaltet und das Verfahren beendet. Alternativ kann im Schritt S510 nur die korrespondierende Spannungsversorgung 3 über das Abschaltsignal R_{A} abgeschaltet werden.

Ausführungsformen der vorliegenden Erfindung können bereits integrierte Spannungsüberwachungen der intern erzeugten Versorgungsspannungen zusätzlich automatisch testen. Eine Freigabe des Systems (volle Funktionalität) ist damit nur möglich, wenn sowohl die Versorgungsspannungen selbst, als auch deren Überwachungsschaltungen und Rücksetzeinrichtungen fehlerfrei sind. Somit ist eine deutliche höhere Robustheit gegenüber latenten Fehlern gegeben. Das Fahrzeugsystem, vorzugsweise ein Airbag-System, wird damit auch immer in einen sicheren Zustand versetzt, sobald die Funktion der Spannungsüberwachung nicht mehr gewährleistet ist. Es ist somit möglich, erweiterte Sicherheitsanforderungen (ASIL-D) zu erfüllen.

## Patentansprüche

1. Vorrichtung zur Überwachung einer Spannungsversorgung (3) für ein Fahrzeugsystem mit mindestens einer Vergleichseinrichtung (14, 24), welche eine Ausgabespannung (Uist) der Spannungsversorgung (3) und/oder eine daraus abgeleitete Spannung (Uist1, Uist2, UTest) als erstes Eingangssignal mit einer vorgegebenen Schwellwertspannung (URef1, URef2) als zweites Eingangssignal vergleicht und ein korrespondierendes Vergleichssignal (V1, V2) ausgibt, und einer Rücksetzeinrichtung (5), welche in Abhängigkeit des mindestens einen Vergleichssignals (V1, V2) mindestens ein Rücksetzsignal (Reset, Nicht-Reset), welches dazu geeignet ist, alle versorgten, aktiven Systembausteine des Fahrzeugsystems in einen sicheren Aus-Zustand zu versetzen, erzeugt,
**dadurch gekennzeichnet, dass**
eine Eigendiagnosefunktion in einem Steuergerät des Fahrzeugsystems oder verteilt in einzelnen Spannungsversorgungen (3) implementiert ist, wobei die Eigendiagnosefunktion einen logischen Zustand des von der mindestens einen Vergleichseinrichtung (14, 24) ausgegebenen Vergleichssignals (V1, V2) in Abhängigkeit eines Eingangssignals (Uist, Uist1, Uist2, UTest) auswertet und überprüft, ob ein mit dem ausgegebenen Vergleichssignal (V1, V2) korrespondierendes Rücksetzsignal (Reset, Nicht-Reset) erzeugbar ist, wobei die Eigendiagnosefunktion eine Fehlfunktion der Vergleichseinrichtung (14, 24) erkennt, wenn der ausgewertete logische Zustand des Vergleichssignals (V1, V2) nicht mit einem erwarteten logischen Zustand übereinstimmt, und wobei die Eigendiagnosefunktion eine Fehlfunktion der Rücksetzeinrichtung (5) erkennt, wenn der überprüfte logische Zustand des Rücksetzsignals (Reset, Nicht-Reset) nicht mit einem erwarteten logischen Zustand übereinstimmt.

2. Vorrichtung nach Anspruch 1, **dadurch gekennzeichnet, dass** die Eigendiagnosefunktion zentral in dem Steuergerät oder verteilt in den einzelnen Spannungsversorgungen (3) implementiert ist, wobei die Eigendiagnosefunktion zur Kurzschlusserkennung ein von der Rücksetzeinrichtung (5) ausgegebenes Rücksetzsignal (Reset, Nicht-Reset) zurückliest und mit einem erwarteten logischen Zustand vergleicht, wobei die Eigendiagnosefunktion eine Fehlfunktion der Rücksetzeinrichtung (5) erkennt, wenn der überprüfte logische Zustand des zurückgelesenen Rücksetzsignals (RR) nicht mit dem erwarteten logischen Zustand übereinstimmt.

3. Vorrichtung nach Anspruch 1 oder 2, **dadurch gekennzeichnet, dass** die Eigendiagnosefunktion in Abhängigkeit von vorgegebenen Zeitpunkten und/oder Systemzuständen die Überprüfung der Vergleichseinrichtung (14, 24) und/oder der Rücksetzeinrichtung (5) durchführt.

4. Vorrichtung nach einem der Ansprüche 1 bis 3, **dadurch gekennzeichnet, dass** eine erste Vergleichseinrichtung (14) einer Unterspannungsüberwachung (10) ein erstes Eingangssignals (Uist1) mit einer vorgegebenen ersten Schwellwertspannung (URef1) als zweites Eingangssignal vergleicht und ein korrespondierendes erstes Vergleichssignal (V1) ausgibt, wobei die Eigendiagnosefunktion den logischen Zustand des ersten Vergleichssignals (V1) während einer Hochlaufphase der Spannungsversorgung (3) erfasst, in welcher das erste Eingangssignal (Uist1) zustandsbedingt niedriger als das zweite Eingangssignal (URef1) ist, und mit einem logischen Zustand des ersten Vergleichssignals (V1) vergleicht, welchen die Eigendiagnosefunktion zu einem nachfolgenden Zeitpunkt erfasst, an welchem die Spannungsversorgung (3) im Betriebszustand ist und das erste Eingangssignal (Uist1) zustandsbedingt höher als das zweite Eingangssignal (URef1) ist, und wobei die Eigendiagnosefunktion eine Fehlfunktion der Unterspannungsüberwachung (10) erkennt, wenn die beiden erfassten logischen Zustände des ersten Vergleichssignals (V1) gleich sind oder nicht mit erwarteten logischen Zuständen übereinstimmen.

5. Vorrichtung nach einem der Ansprüche 1 bis 4, **dadurch gekennzeichnet, dass** eine zweite Vergleichseinrichtung (24) einer Überspannungsüberwachung (20) eine aus der Ausgabespannung (Uist) der Spannungsversorgung (3) abgeleitete erste Spannung (UTest) als ein erstes Eingangssignal mit einer vorgegebenen zweiten Schwellwertspannung (URef2) als zweites Eingangssignal vergleicht und ein korrespondierendes zweites Vergleichssignal (V2) ausgibt, wobei die Eigendiagnosefunktion den logischen Zustand des zweiten Vergleichssignals (V2) während einer Betriebsphase der Spannungsversorgung (3) erfasst, in welcher das erste Eingangssignal (UTest) zustandsbedingt höher als das zweite Eingangssignal (URef1) ist, wobei die Eigendiagnosefunktion zu einem nachfolgenden Zeitpunkt über eine Umschalteinheit (30) eine aus der Ausgabespannung (Uist) der Spannungsversorgung (3) abgeleitete zweite Spannung (Uist2) als erstes Eingangssignal an die zweite Vergleichseinheit (24) anlegt, welche zustandsbedingt niedriger als die zweite Eingangsspannung (URef2) ist, und den korrespondierenden logischen Zustand des zweiten Vergleichssignals (V2) mit dem vorherigen logischen Zustand des zweiten Vergleichssignals (V2) vergleicht, und wobei die Eigendiagnosefunktion eine Fehlfunktion der Überspannungsüberwachung (20) erkennt, wenn die beiden erfassten logischen Zustände des zweiten Vergleichssignals (V2) gleich sind oder nicht mit erwarteten logischen Zuständen übereinstimmen.

6. Verfahren zur Überwachung einer Spannungsversorgung (3) für ein Fahrzeugsystem, wobei über eine Vergleichseinrichtung (14, 24) eine Ausgabespannung (Uᵢₛₜ) der Spannungsversorgung (3) und/oder eine daraus abgeleitete Spannung (Uᵢₛₜ₁, Uᵢₛₜ₂, U_{Test}) als erstes Eingangssignal mit einer vorgegebenen Schwellwertspannung (U_{Ref1}, U_{Ref2}) als zweites Eingangssignal verglichen und ein korrespondierendes Vergleichssignal (V1, V2) erzeugt wird, und wobei über eine Rücksetzeinrichtung (5) in Abhängigkeit des mindestens einen Vergleichssignals (V1, V2) mindestens ein Rücksetzsignal (Reset, Nicht-Reset), welches dazu geeignet ist, alle versorgten, aktiven Systembausteine des Fahrzeugsystems in einen sicheren Aus-Zustand zu versetzen, erzeugt wird,
**dadurch gekennzeichnet, dass**
eine Eigendiagnosefunktion in einem Steuergerät des Fahrzeugsystems oder in der Spannungsversorgung (3) implementiert ist, wobei die Eigendiagnosefunktion einen logischer Zustand des von der mindestens einen Vergleichseinrichtung (14, 24) ausgegebenen Vergleichssignals (V1, V2) in Abhängigkeit eines Eingangssignals (Uᵢₛₜ, Uᵢₛₜ₁, Uᵢₛₜ₂, U_{Test}) auswertet wird und daraufhin überprüft wird, ob ein mit dem ausgegebenen Vergleichssignal (V1, V2) korrespondierendes Rücksetzsignal (Reset, Nicht-Reset) erzeugt werden kann, wobei eine Fehlfunktion der Vergleichseinrichtung (14, 24) von der Eigendiagnosefunktion erkannt wird, wenn der ausgewertete logische Zustand des Vergleichssignals (V1, V2) nicht mit einem erwarteten logischen Zustand übereinstimmt, und wobei eine Fehlfunktion der Rücksetzeinrichtung (5) von der Eigendiagnosefunktion erkannt wird, wenn der überprüfte logische Zustand des Rücksetzsignals (Reset, Nicht-Reset) nicht mit einem erwarteten logischen Zustand übereinstimmt.

7. Verfahren nach Anspruch 6, **dadurch gekennzeichnet, dass** zur Kurzschlusserkennung ein ausgegebenes Rücksetzsignal (Reset, Nicht-Reset) von der Eigendiagnosefunktion zurückgelesen und mit einem erwarteten logischen Zustand verglichen wird, wobei eine Fehlfunktion der Rücksetzeinrichtung (5) von der Eigendiagnosefunktion erkannt wird, wenn der überprüfte logische Zustand des Rücksetzsignals (R_{R}) nicht mit dem erwarteten logischen Zustand übereinstimmt.

8. Verfahren nach Anspruch 7 oder 8, **dadurch gekennzeichnet, dass** die Eigendiagnosefunktion in Abhängigkeit von vorgegebenen Zeitpunkten und/oder Systemzuständen durchgeführt wird.

9. Verfahren nach einem der Ansprüche 6 bis 8, **dadurch gekennzeichnet, dass** eine erste Vergleichseinrichtung einer Unterspannungsüberwachung (14) ein erstes Eingangssignals (Uᵢₛₜ₁) mit einer vorgegebenen ersten Schwellwertspannung (U_{Ref1}) als zweites Eingangssignal vergleicht und ein korrespondierendes erstes Vergleichssignal (V1) ausgibt, wobei der logische Zustand des ersten Vergleichssignals (V1) während einer Hochlaufphase der Spannungsversorgung (3), in welcher das erste Eingangssignal (Uᵢₛₜ₁) zustandsbedingt niedriger als das zweite Eingangssignal (U_{Ref1}) ist, von der Eigendiagnosefunktion erfasst und mit einem logischen Zustand des ersten Vergleichssignals (V1) verglichen wird, welcher von der Eigendiagnosefunktion zu einem nachfolgenden Zeitpunkt erfasst wird, an welchem die Spannungsversorgung (3) im Betriebszustand ist und das erste Eingangssignal (Uᵢₛₜ₁) zustandsbedingt höher als das zweite Eingangssignal (U_{Ref1}) ist, und wobei eine Fehlfunktion der Unterspannungsüberwachung (10) von der Eigendiagnosefunktion erkannt wird, wenn die beiden erfassten logischen Zustände des ersten Vergleichssignals (V1) gleich sind oder nicht mit erwarteten logischen Zuständen übereinstimmen.

10. Verfahren nach einem der Ansprüche 6 bis 9, **dadurch gekennzeichnet, dass** eine Überspannungsüberwachung (20) einer zweiten Vergleichseinrichtung (24) eine aus der Ausgabespannung (Uᵢₛₜ) der Spannungsversorgung (3) abgeleitete erste Spannung (U_{Test}) als ein erstes Eingangssignals mit einer vorgegebenen zweiten Schwellwertspannung (U_{Ref2}) als zweites Eingangssignal vergleicht und ein korrespondierendes zweites Vergleichssignal (V2) ausgibt, wobei der logische Zustand des zweiten Vergleichssignals (V2) während einer Betriebsphase der Spannungsversorgung (3), in welcher das erste Eingangssignal (U_{Test}) zustandsbedingt höher als das zweite Eingangssignal (U_{Ref1}) ist, von der Eigendiagnosefunktion erfasst wird, welche zu einem nachfolgenden Zeitpunkt eine aus der Ausgabespannung (Uᵢₛₜ) der Spannungsversorgung (3) abgeleitete zweite Spannung (Uᵢₛₜ₂) als erstes Eingangssignal an die zweite Vergleichseinheit (24) anlegt, welche zustandsbedingt niedriger als die zweite Eingangsspannung (U_{Ref2}) ist, und den korrespondierenden logischen Zustand des zweiten Vergleichssignals (V2) mit dem vorherigen logischen Zustand des zweiten Vergleichssignals (V2) vergleicht, und wobei eine Fehlfunktion der Überspannungsüberwachung (20) von der Eigendiagnosefunktion erkannt wird, wenn die beiden erfassten logischen Zustände des zweiten Vergleichssignals (V2) gleich sind oder nicht mit erwarteten logischen Zuständen übereinstimmen.

## Claims

1. Device for monitoring a voltage supply (3) for a vehicle system having at least one comparator apparatus (14, 24) which compares an output voltage (Uist) of the voltage supply (3) and/or a voltage (Uist1, Uist2, UTest) derived therefrom as a first input signal with a specified threshold value signal (URef1, URef2) as a second input voltage and outputs a corresponding comparison signal (V1, V2), and a reset apparatus (5) which generates, in accordance with the at least one comparison signal (V1, V2), at least one reset signal (reset, not-reset) which is suitable for placing all the supplied active system modules of the vehicle system in a safe off state,
**characterized in that**
a self-diagnostic function is implemented in a control unit of the vehicle system or distributed in individual voltage supplies (3), wherein the self-diagnostic function evaluates a logic state of the comparison signal (V1, V2), which is output by the at least one comparator apparatus (14, 24), in accordance with an input signal (Uist, Uist1, Uist2, UTest) and checks whether a reset signal (reset, not-reset) which corresponds to the comparison signal (V1, V2) which is output can be generated, wherein the self-diagnostic function detects a malfunction of the comparator apparatus (14, 24) if the evaluated logic state of the comparison signal (V1, V2) does not correspond to an expected logic state, and wherein the self-diagnostic function detects a malfunction of the reset apparatus (5) if the checked logic state of the reset signal (reset, not-reset) does not correspond to an expected logic state.

2. Device according to Claim 1, **characterized in that** the self-diagnostic function is implemented centrally in the control unit or distributed in the individual voltage supplies (3), wherein the self-diagnostic function reads back, for the purpose of detecting a short circuit, a reset signal (reset, not-reset) which is output by the reset apparatus (5) and compares it with an expected logic state, wherein the self-diagnostic function detects a malfunction of the reset apparatus (5) if the checked logic state of the read-back reset signal (RR) does not correspond to the expected logic state.

3. Device according to Claim 1 or 2, **characterized in that** the self-diagnostic function carries out the checking of the comparator apparatus (14, 24) and/or of the reset apparatus (5) in accordance with specified points in time and/or system states.

4. Device according to one of Claims 1 to 3, **characterized in that** a first comparator apparatus (14) of an undervoltage monitoring means (10) compares a first input signal (Uist1) with a specified first threshold value voltage (URef1) as a second input signal and outputs a corresponding first comparison signal (V1), wherein the self-diagnostic function detects the logic state of the first comparison signal (V1) during a runup phase of the voltage supply (3) in which the first input signal (Uist1) is, for state-related reasons, lower than the second input signal (URef1) and compares it with a logic state of the first comparison signal (V1), which state is detected by the self-diagnostic function at a following point in time at which the voltage supply (3) is in the operating state and the first input signal (Uist1) is, for state-related reasons, higher than the second input signal (URef1), and wherein the self-diagnostic function detects a malfunction of the undervoltage monitoring means (10) if the two detected logic states of the first comparison signal (V1) are the same or do not correspond to expected logic states.

5. Device according to one of Claims 1 to 4, **characterized in that** a second comparator apparatus (24) of an overvoltage monitoring means (20) compares a first voltage (UTest) derived from the output voltage (Uist) of the voltage supply (3) as a first input signal with a specified second threshold value voltage (URef2) as a second input signal and outputs a corresponding second comparison signal (V2), wherein the self-diagnostic function detects the logic state of the second comparison signal (V2) during an operating phase of the voltage supply (3), in which operating phase the first input signal (UTest) is, for state-related reasons, higher than the second input signal (URef1), wherein the self-diagnostic function applies, at a following point in time via a switching unit (30), a second voltage (Uist2) derived from the output voltage (Uist) of the voltage supply (3) as a first input signal to the second comparator unit (24), which, for state-related reasons, is lower than the second input voltage (URef2) and compares the corresponding logic state of the second comparison signal (V2) with the previous logic state of the second comparison signal (V2), and wherein the self-diagnostic function detects a malfunction of the overvoltage monitoring means (20) if the two detected logic states of the second comparison signal (V2) are the same or do not correspond to expected logic states.

6. Method for monitoring a voltage supply (3) for a vehicle system, wherein an output voltage (Uist) of the voltage supply (3) and/or a voltage (Uᵢₛₜ₁, Uᵢₛₜ₂, U_{Test}) derived therefrom is compared as a first input signal with a specified threshold value voltage (U_{Ref1}, U_{R}E_{f2}) as a second input signal via a comparation apparatus (14, 24), and a corresponding comparison signal (V1, V2) is generated, and wherein at least one reset signal (reset, not-reset), which is suitable for placing all the supplied active system modules of the vehicle system in a safe off state, is generated via a reset apparatus (S) in accordance with the at least one comparison signal (V1, V2),
**characterized in that**
a self-diagnostic function is implemented in a control unit of the vehicle system or in the voltage supply (3), wherein the self-diagnostic function evaluates a logic state of the comparison signal (V1, V2) which is output by the at least one comparator apparatus (14, 24), in accordance with an input signal (Uᵢₛₜ, Uᵢₛₜ₁, Uᵢₛₜ₂, U_{Test}) and it is subsequently checked whether a reset signal (reset, not-reset) which corresponds to the comparison signal (V1, V2) which is output can be generated, wherein a malfunction of the comparator apparatus (14, 24) is detected by the self-diagnostic function of the evaluated logic state if the comparison signal (V1, V2) does not correspond to an expected logic state, and wherein a malfunction of the reset apparatus (5) is detected by the self-diagnostic function if the checked logic state of the reset signal (reset, not-reset) does not correspond to an expected logic state.

7. Method according to Claim 6, **characterized in that**, in order to detect a short circuit, a reset signal (reset, not-reset) which is output is read back by the self-diagnostic function and is compared with an expected logic state, wherein a malfunction of the reset apparatus (5) is detected by the self-diagnostic function if the checked logic state of the reset signal (R_{R}) does not correspond to the expected logic state.

8. Method according to Claim 7 or 8, **characterized in that** the self-diagnostic function is carried out in accordance with specified points in time and/or system states.

9. Method according to one of Claims 6 to 8, **characterized in that** a first comparator apparatus of an undervoltage monitoring means (14) compares a first input signal (Uᵢₛₜ₁) with a specified first threshold value voltage (U_{Ref1}) as a second input signal and outputs a corresponding first comparison signal (V1), wherein the logic state of the first comparison signal (V1) during a runup phase of the voltage supply (3) in which the first input signal (Uᵢₛₜ₁) is, for state-related reasons, lower than the second input signal (U_{Ref1}) is detected by the self-diagnostic function and compared with a logic state of the first comparison signal (V1), which state is detected by the self-diagnostic function at a following point in time at which the voltage supply (3) is in the operating state and the first input signal (Uᵢₛₜ₁) is, for state-related reasons, higher than the second input signal (U_{Ref1}), and wherein a malfunction of the undervoltage monitoring means (10) is detected by the self-diagnostic function if the two detected logic states of the first comparison signal (V1) are the same or do not correspond to expected logic states.

10. Method according to one of Claims 6 to 9, **characterized in that** an overvoltage monitoring means (20) of a second comparator apparatus (24) compares a first voltage (U_{Test}) derived from the output voltage (Uᵢₛₜ) of the voltage supply (3) as a first input signal with a specified second threshold value voltage (U_{Ref2}) as a second input signal, and outputs a corresponding second comparison signal (V2), wherein the logic state of the second comparison signal (V2) during an operating phase of the voltage supply (3) in which the first input signal (U_{Test}) is, for state-related reasons, higher than the second input signal (U_{Ref1}) is detected by the self-diagnostic function which applies, at a following point in time, a second voltage (Uᵢₛₜ₂) derived from the output voltage (Uᵢₛₜ) of the voltage supply (3) as a first input signal to the second comparator unit (24) which is, for state-related reasons, lower than the second input voltage (U_{Ref2}), and compares the corresponding logic state of the second comparison signal (V2) with the previous logic state of the second comparison signal (V2), and wherein a malfunction of the overvoltage monitoring means (20) is detected by the self-diagnostic function if the two detected logic states of the second comparison signal (V2) are the same or do not correspond to expected logic states.

## Revendications

1. Arrangement de surveillance d'une alimentation électrique (3) pour un système de véhicule, comprenant au moins un dispositif de comparaison (14, 24) qui compare une tension de sortie (Uist) de l'alimentation électrique (3) et/ou une tension (Uist1, Uist2, UTest) qui en est dérivée en tant que premier signal d'entrée avec une tension de seuil (URef1, URef2) prédéfinie en tant que deuxième signal d'entrée et délivre un signal de comparaison (V1, V2) correspondant, et un dispositif de réinitialisation (5) qui, en fonction de l'au moins un signal de comparaison (V1, V2), génère au moins un signal de réinitialisation (Reset, Nicht-Reset) qui est adapté pour amener tous les composants de système alimentés actifs du système de véhicule dans un état d'arrêt sécurisé,
**caractérisé en ce que**
une fonction d'autodiagnostic est mise en oeuvre dans un contrôleur du système de véhicule ou de manière distribuée dans des alimentations électriques individuelles (3), la fonction d'autodiagnostic interprétant un état logique du signal de comparaison (V1, V2) délivré par l'au moins un dispositif de comparaison (14, 24) en fonction d'un signal d'entrée (Uist, Uist1, Uist2, UTest) et vérifiant si un signal de réinitialisation (Reset, Nicht-Reset) correspondant au signal de comparaison (V1, V2) délivré peut être généré, la fonction d'autodiagnostic reconnaissant un défaut de fonctionnement du dispositif de comparaison (14, 24) lorsque l'état logique interprété du signal de comparaison (V1, V2) ne coïncide pas avec un état logique attendu, et la fonction d'autodiagnostic reconnaissant un défaut de fonctionnement du dispositif de réinitialisation (5) lorsque l'état logique vérifié du signal de réinitialisation (Reset, Nicht-Reset) ne coïncide pas avec un état logique attendu.

2. Arrangement selon la revendication 1, **caractérisé en ce que** la fonction d'autodiagnostic est mise en oeuvre de manière centralisée dans le contrôleur ou de manière distribuée dans les alimentations électriques individuelles (3), la fonction d'autodiagnostic, en vue de reconnaître un court-circuit, relisant un signal de réinitialisation (Reset, Nicht-Reset) délivré par le dispositif de réinitialisation (5) et le comparant avec un état logique attendu, la fonction d'autodiagnostic reconnaissant un défaut de fonctionnement du dispositif de réinitialisation (5) lorsque l'état logique vérifié du signal de réinitialisation relu (RR) ne coïncide pas avec l'état logique attendu.

3. Arrangement selon la revendication 1 ou 2, **caractérisé en ce que** la fonction d'autodiagnostic réalise la vérification du dispositif de comparaison (14, 24) et/ou du dispositif de réinitialisation (5) en fonction d'instants et/ou d'états de système prédéfinis.

4. Arrangement selon l'une des revendications 1 à 3, **caractérisé en ce qu'**un premier dispositif de comparaison (14) d'une surveillance de sous-tension (10) compare un premier signal d'entrée (Uist1) avec une première tension de seuil (URef1) prédéfinie en tant que deuxième signal d'entrée et délivre un premier signal de comparaison (V1) correspondant, la fonction d'autodiagnostic détectant l'état logique du premier signal de comparaison (V1) pendant une phase de montée de l'alimentation électrique (3), durant laquelle le premier signal d'entrée (Uist1), du fait de l'état, est plus faible que le deuxième signal d'entrée (URef1), et le comparant à un état logique du premier signal de comparaison (V1) que détecte la fonction d'autodiagnostic à un instant ultérieur auquel l'alimentation électrique (3) se trouve dans l'état opérationnel et, du fait de l'état, le premier signal d'entrée (Uist1) est plus élevé que le deuxième signal d'entrée (URef1), et la fonction d'autodiagnostic reconnaissant un défaut de fonctionnement de la surveillance de sous-tension (10) lorsque les deux états logiques détectés du premier signal de comparaison (V1) sont égaux ou ne coïncident pas avec des états logiques attendus.

5. Arrangement selon l'une des revendications 1 à 4, **caractérisé en ce qu'**un deuxième dispositif de comparaison (24) d'une surveillance de surtension (20) compare une première tension (UTest) dérivée de la tension de sortie (Uist) de l'alimentation électrique (3) en tant que premier signal d'entrée avec une deuxième tension de seuil (URef2) prédéfinie en tant que deuxième signal d'entrée et délivre un deuxième signal de comparaison (V2) correspondant, la fonction d'autodiagnostic détectant l'état logique du deuxième signal de comparaison (V2) pendant une phase de fonctionnement de l'alimentation électrique (3), durant laquelle le premier signal d'entrée (UTest), du fait de l'état, est plus élevé que le deuxième signal d'entrée (URef1), et la fonction d'autodiagnostic, à un instant ultérieur, appliquant à la deuxième unité de comparaison (24), par le biais d'une unité d'inversion (30), une deuxième tension (Uist2) dérivée de la tension de sortie (Uist) de l'alimentation électrique (3) en tant que premier signal d'entrée qui, du fait de l'état, est plus faible que la deuxième tension d'entrée (URef2), et comparant l'état logique correspondant du deuxième signal de comparaison (V2) avec l'état logique précédent du deuxième signal de comparaison (V2), et la fonction d'autodiagnostic reconnaissant un défaut de fonctionnement de la surveillance de surtension (20) lorsque les deux états logiques détectés du deuxième signal de comparaison (V2) sont égaux ou ne coïncident pas avec des états logiques attendus.

6. Procédé de surveillance d'une alimentation électrique (3) pour un système de véhicule, une tension de sortie (Uᵢₛₜ) de l'alimentation électrique (3) et/ou une tension (Uᵢₛₜ₁, Uᵢₛₜ₂, U_{Test}) qui en est dérivée en tant que premier signal d'entrée étant comparée avec une tension de seuil (U_{Ref1,} U_{Ref2}) prédéfinie en tant que deuxième signal d'entrée par le biais d'un dispositif de comparaison (14, 24) et un signal de comparaison (V1, V2) correspondant étant généré, et au moins un signal de réinitialisation (Reset, Nicht-Reset), qui est adapté pour amener tous les composants de système alimentés actifs du système de véhicule dans un état d'arrêt sécurisé, étant généré par le biais d'un dispositif de réinitialisation (5) en fonction de l'au moins un signal de comparaison (V1, V2),
**caractérisé en ce que**
une fonction d'autodiagnostic est mise en oeuvre dans un contrôleur du système de véhicule ou dans l'alimentation électrique (3), la fonction d'autodiagnostic interprétant un état logique du signal de comparaison (V1, V2) délivré par l'au moins un dispositif de comparaison (14, 24) en fonction d'un signal d'entrée (U_{ist,} Uᵢₛₜ₁, Uᵢₛₜ₂, U_{Test}) et un contrôle étant ensuite effectué afin de vérifier si un signal de réinitialisation (Reset, Nicht-Reset) correspondant au signal de comparaison (V1, V2) délivré peut être généré, un défaut de fonctionnement du dispositif de comparaison (14, 24) étant reconnu par la fonction d'autodiagnostic lorsque l'état logique interprété du signal de comparaison (V1, V2) ne coïncide pas avec un état logique attendu, et un défaut de fonctionnement du dispositif de réinitialisation (5) étant reconnu par la fonction d'autodiagnostic lorsque l'état logique vérifié du signal de réinitialisation (Reset, Nicht-Reset) ne coïncide pas avec un état logique attendu.

7. Procédé selon la revendication 6, **caractérisé en ce qu'**en vue de reconnaître un court-circuit, un signal de réinitialisation (Reset, Nicht-Reset) délivré est relu par la fonction d'autodiagnostic et comparé avec un état logique attendu, un défaut de fonctionnement du dispositif de réinitialisation (5) étant reconnu par la fonction d'autodiagnostic lorsque l'état logique vérifié du signal de réinitialisation (R_{R}) ne coïncide pas avec l'état logique attendu.

8. Procédé selon la revendication 7 ou 8, **caractérisé en ce que** la fonction d'autodiagnostic est accomplie en fonction d'instants et/ou d'états de système prédéfinis.

9. Procédé selon l'une des revendications 6 à 8, **caractérisé en ce qu'**un premier dispositif de comparaison d'une surveillance de sous-tension (14) compare un premier signal d'entrée (Uᵢₛₜ₁) avec une première tension de seuil (U_{Ref1}) prédéfinie en tant que deuxième signal d'entrée et délivre un premier signal de comparaison (V1) correspondant, l'état logique du premier signal de comparaison (V1) pendant une phase de montée de l'alimentation électrique (3), durant laquelle le premier signal d'entrée (Uᵢₛₜ₁), du fait de l'état, est plus faible que le deuxième signal d'entrée (U_{Ref1}) étant détecté par la fonction d'autodiagnostic et comparé à un état logique du premier signal de comparaison (V1) qui est détecté par la fonction d'autodiagnostic à un instant ultérieur auquel l'alimentation électrique (3) se trouve dans l'état opérationnel et, du fait de l'état, le premier signal d'entrée (Uᵢₛₜ₁) est plus élevé que le deuxième signal d'entrée (U_{Ref1}), et un défaut de fonctionnement de la surveillance de sous-tension (10) étant reconnu par la fonction d'autodiagnostic lorsque les deux états logiques détectés du premier signal de comparaison (V1) sont égaux ou ne coïncident pas avec des états logiques attendus.

10. Procédé selon l'une des revendications 6 à 9, **caractérisé en ce qu'**une surveillance de surtension (20) d'un deuxième dispositif de comparaison (24) compare une première tension (U_{Test}) dérivée de la tension de sortie (Uᵢₛₜ) de l'alimentation électrique (3) en tant que premier signal d'entrée avec une deuxième tension de seuil (U_{Ref2}) prédéfinie en tant que deuxième signal d'entrée et délivre un deuxième signal de comparaison (V2) correspondant, l'état logique du deuxième signal de comparaison (V2) pendant une phase de fonctionnement de l'alimentation électrique (3), durant laquelle le premier signal d'entrée (U_{Test}) , du fait de l'état, est plus élevé que le deuxième signal d'entrée (U_{Ref1}) étant détecté par la fonction d'autodiagnostic, laquelle, à un instant ultérieur, applique à la deuxième unité de comparaison (24) une deuxième tension (Uᵢₛₜ₂) dérivée de la tension de sortie (Uᵢₛₜ) de l'alimentation électrique (3) en tant que premier signal d'entrée qui, du fait de l'état, est plus faible que la deuxième tension d'entrée (U_{Ref2}), et compare l'état logique correspondant du deuxième signal de comparaison (V2) avec l'état logique précédent du deuxième signal de comparaison (V2), et un défaut de fonctionnement de la surveillance de surtension (20) étant reconnu par la fonction d'autodiagnostic lorsque les deux états logiques détectés du deuxième signal de comparaison (V2) sont égaux ou ne coïncident pas avec des états logiques attendus.
